# EUROPEAN PATENT SPECIFICATION

(11) **EP 0 725 935 B1**
(45) Date of publication and mention of the grant of the patent: **26.01.2005**
(21) Application number: 94908133.5
(22) Date of filing: 11.08.1993
(51) Int. Cl.: G01R 31/04

(54) **A DEVICE FOR THE AUTOMATIC CONTROL OF JOINTS IN ELECTRICAL HIGH VOLTAGE LINES**
ANORDNUNG ZUR AUTOMATISCHEN KONTROLLE VON VERBINDUNGEN IN ELEKTRISCHEN HOCHSPANNUNGSLEITUNGEN
DISPOSITIF DE COMMANDE AUTOMATIQUE DE CONNEXIONS DANS DES LIGNES ELECTRIQUES A HAUTE TENSION

(30) Priority: 12.08.1992 SE 9202359
(43) Date of publication of application: 14.08.1996
(73) Proprietor: VATTENFALL AB, S-162 87 Vällingby (SE)
(72) Inventor: SEGERSTRÖM, Bo, Torbjörn, S-640 30 Sparreholm (SE)
(74) Representative: Lundquist, Arne
(86) International application number: PCT/SE1993/000666
(87) International publication number: WO 1994/004936

(56) References cited:
- US-A- 4 794 327
- US-A- 4 818 990
- US-A- 4 904 996
- ERA, Volume 6-7, June 1993, PETER JANSSON, "Lagar Ledningar Utan Avbrott".

## Description

The present invention relates to a device for the automatic control of joints in lines for electric high voltage, comprising a support, at least one driving wheel for engaging a line, a driving device for driving said wheel, a first remote control device for the control of said driving device, means for remotely controlled, automatic measurement of physical data at said joint comprising necessary circuits and means for the transfer of measurement data to a receiver, said means for remotely controlled, automatic measurement of physical data being designed for non contacting as well as contacting measurement in the vicinity of and at the joint in question, shielding means for shielding the means for remotely controlled, automatic measurement of physical data at said joint, to achieve a uniform potential.
Such a device is known from US Patent No 4, 904,996. This device is designed to travel on a high voltage line and to make contact and non contact measurements made by a video camera, IR thermal imaging, UV and acoustic sensors, voltmeters etc on the line and its joints. The device is designed to be mounted on or removed from an energized high voltage conductor, i.e. line, using two bucket truck crews, mounting two propulsion modules simultaneously, using hot sticks or a helium blimp for lifting the device over an obstruction. The device according to US 4,904,966 thus has certain limitations as to the mounting method.

The object of the present invention thus is to provide a device of the type mentioned by way of introduction, that can be utilized when the high voltage line is in operation and that is generally usable for all types of physical measurements and that can safely be steered in to lie upon the line, that is to be controlled.

According to the invention such a device is defined in present claim 1.

In one advantageous embodiment of the invention, the support in addition to said driving wheel is provided with at least one second wheel parallel, at a distance perpendicular to said driving wheel, the second wheel being adjustable as to the distance perpendicular to the driving wheel. With this arrangement the device can be adapted to utlization in high voltage systems with parallel lines.

Advantageously the guide rail means comprise two substantially triangle formed guide elements, each of them attached to its horizontal side of said support, diverging downwards, outwardly.

The lifting means most effectively consists of a helicopter. Considering the need for being able to release the device from the helicopter in case of emergency it is suitable to provide a remotely controlled releaseable lifting element between the support and the lifting means.

This lifting element can be constructed in different ways. The device may comprise a guide means attached to said support, e g in the form of a hopper, diverging upwardly, the guide means being provided with a first locking element. A second locking element is attached to a line means intended to be carried by said lifting means.The first and second locking elements are constructed to form together automatically said lifting element in the form of a locking, carrying joint, remotely controlled releasable.

For safety reasons, insulators should be arranged between the lifting element and the support, also if the line means is per se non electrical conducting, e g from Kevlar®.

The means for transferring of measurement data to a receiver, in the helicopter, if such one is utilized, suitably comprises a fibre optical link. Considering the need for being able to separate the lifting means, e.g. a helicopter from the support, the fibre optical link suitably comprises a first and a second part, which are kept in fibre optical connection by a connecting means, which is formed to bring the two parts apart under the influence of a predetermined tensile force.

A means for the measurement of electrical voltage over the joint suitably comprises two pointed elements, provided to automatically, by remote control,penetrate into the surface layer of the line and thus form the ends of an electrical measurement shunt circuit over the joint.

A means for the measurement of the amperage through the joint on the other hand, suitably comprises a measurement loop, that is formed from at least two clamp parts,in such a way, that it will automatically open and then close around the line when it is led against this, and automatically open when it is drawn from the line.

The invention will be described in the following, reference being made to the accompanying schematic figures.

Of these,
figure 1A shows a view of part of one embodiment of the device according to the invention, partly in section,
figure 1B shows a second locking element, intended to be carried, via a line means by a lifting means, like a helicopter,
figure 1C shows a first device for remotely controlling of the driving device and automatical measurement of physical data,
figure 1D shows a second device for remotely controlling the second locking element,
figure 2 shows a guide rail means for steering of the device to lying against the line,
figure 3 shows an alternative form of lifting the support with insulators and two line means,
figure 4 shows a view along two lines of the guide rail means with driving wheels, and an extra wheel,
figure 5 shows a driving wheel with an adjustable extra wheel,
figure 6 shows an alternative embodiment of the device according to the invention, carried by a helicopter,
figure 7 shows a detail of a releasable lifting element and a fibre optical link in two parts with releasable connecting means,
figure 8 shows a view of a means for measurement of the amperage through a joint.

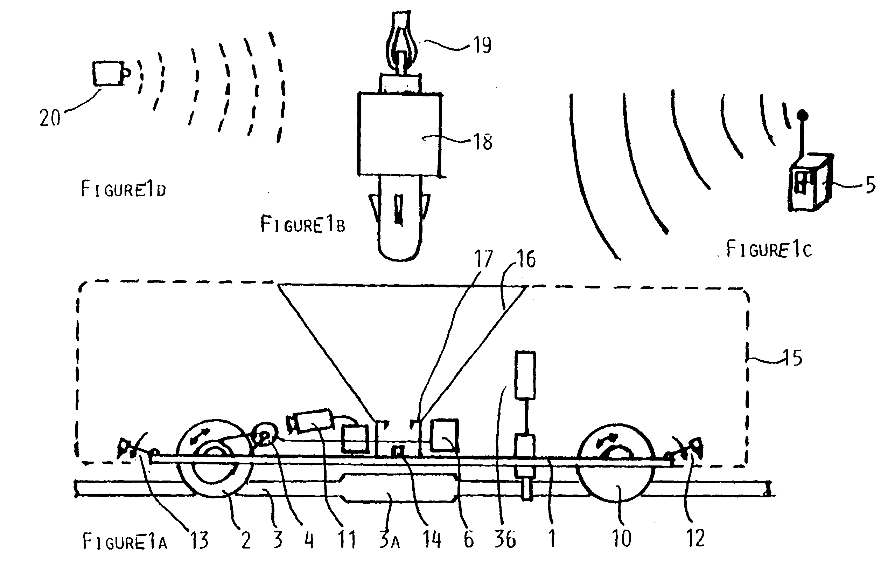

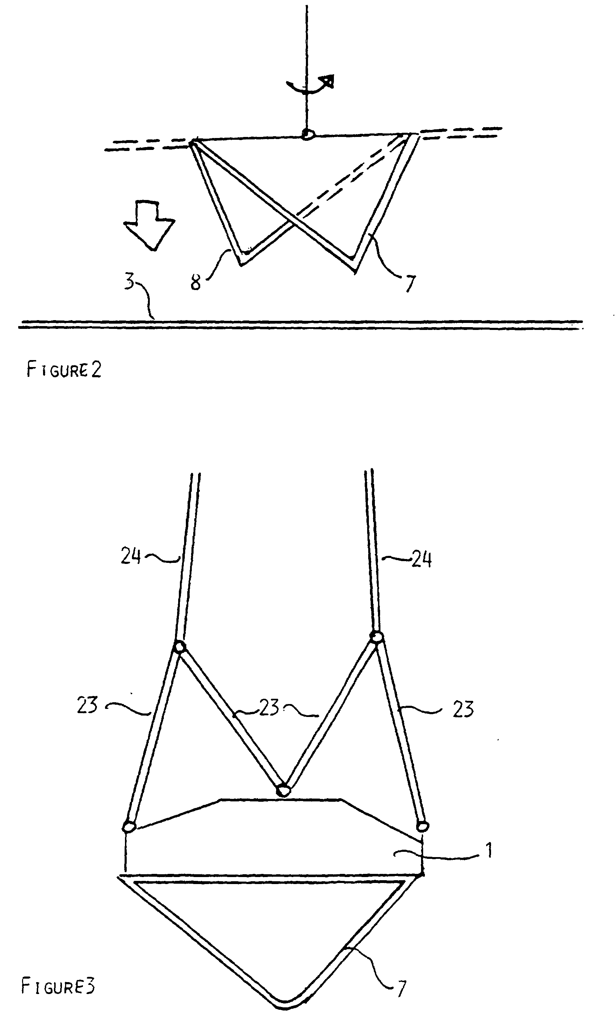

In figure 1A a first support is denoted by 1, a driving wheel by 2, for applying to a line 3, driven by a driving device 4. A first remotely controlled device for controlling of said driving device 4 comprises a transmitter 5 and a receiver 6. From figure 2 the form of guide rail means 7,8 for steering of the device to lying of its driving wheel 2 and other wheel 10 on the line 3 and its joint 3A can be seen . A camera means 11 with a device for remotely transferring of a picture of the joint 3A and its environments is shown in figure 1A. Furthermore there are means for remotely controlled automatic measurement of physical data at said joint 3A, namely two pointed elements 12, 13, which are arranged to automatically, by remote control, be brought to penetrate into the surface layer of the line 3 and thus form the ends of an electrical measurement shunt loop over the joint 3A. Furthermore there are means 36 for the measurement of the amperage though the joint 3A. This means can, as is shown in figure 8, be formed like a spring tensioned claw, that opens when it is led over the line, and then closes around the line, so that a circuit is formed in a way known per se, for the measurement of the amperage through the line and thus through the joint 3A. According to figure 8 the means comprises two guide plates 37, 38, each of them attached to a ring halve 39 and 40 made by iron, which are kept together by a spring 41. On one of the ring halves, there is provided a coil as part of a circuit 42, in which a current is induced, the strength of which can be read on the amperemeter 43.

The device is furthermore provided with necessary measurement circuits 14 and means for the wireless transfer of measurement data to a receiver. An important part of the device is a shielding device 15 for shielding of said means for the automatical measurement of physical data to uniform potential.

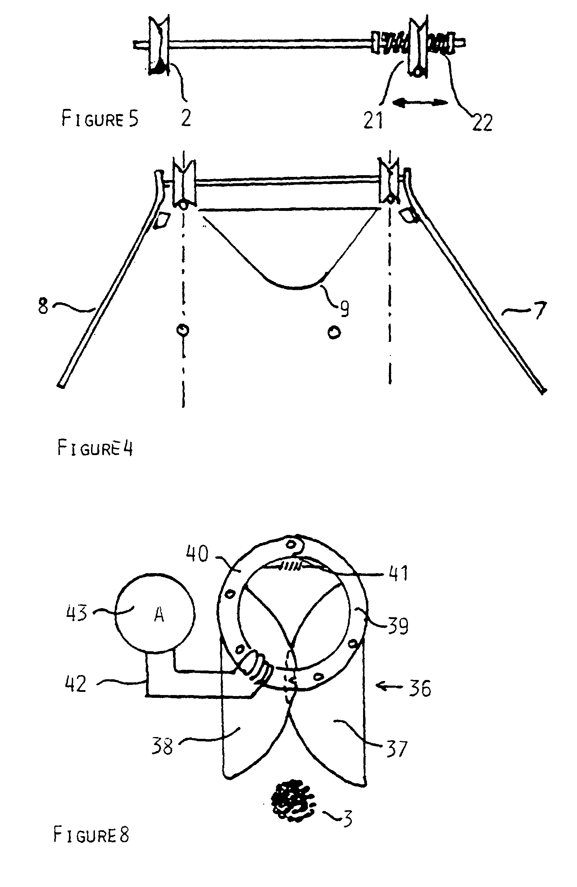

The device comprises, furthermore, a guide means 16 in the form of a hopper, open upwardly, provided with a first locking element 17, intended to cooperate with a second locking means 18, attached to a line means intended to be carried by a lifting means like a helicopter or a crane. The locking elements 17, 18 are constructed to form automatically, a locking, carrying joint, which is releasable by the remote control of a second remote control device 20. In figures 4 and 5 an embodiment of the device is shown, with an extra wheel 21 on the same shaft as the driving wheel 2, intended to lie on a line parallel to the first line 3. In an alternative embodiment the extra wheel 21 is spring tensioned 22 in order to be adaptable to somewhat varying distances between the lines.

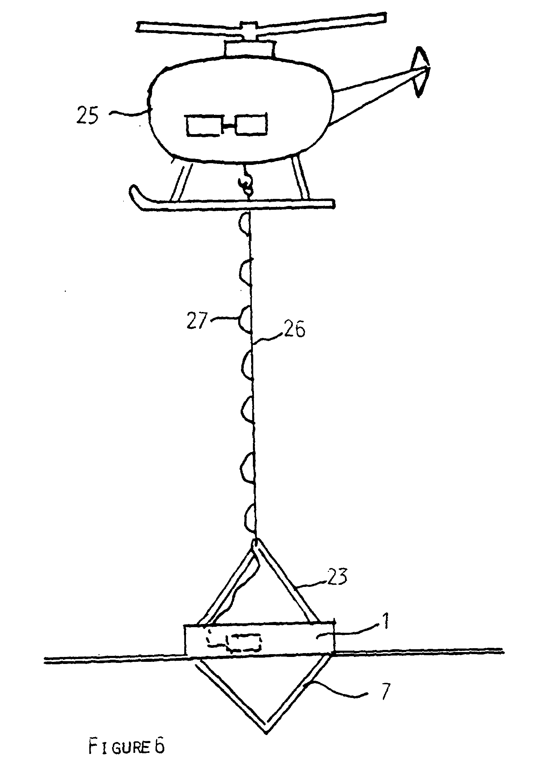

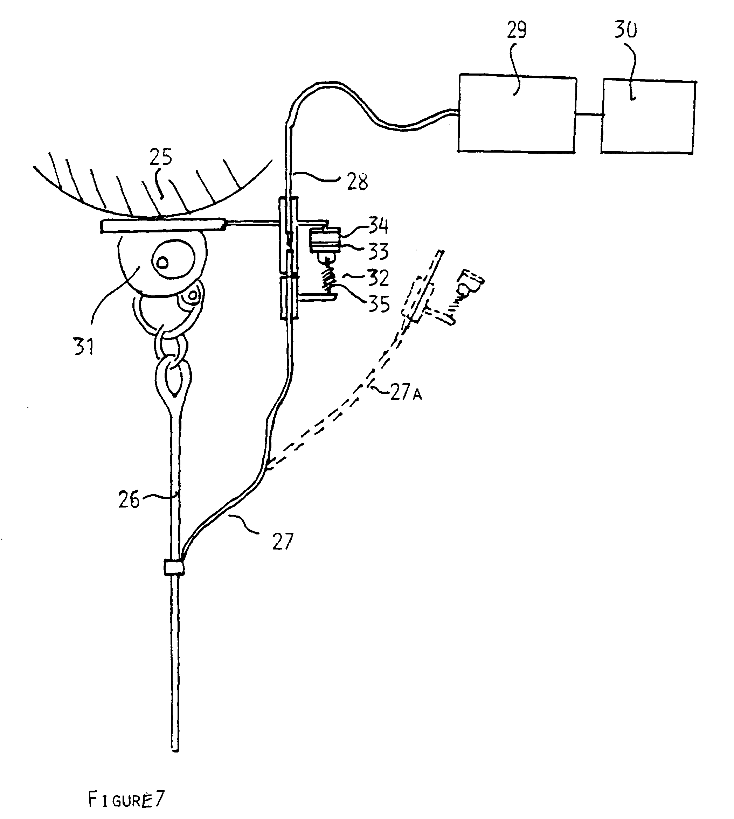

In the figures 3, 6 and 7 there is shown an alternative embodiment of the device according to the invention. In this four insulators 23 are provided, attached to the support 1. They are also, as is shown in figure 3 connected to two line means 24, which are carried by the lifting means in question, in figures 6 and 7 shown with a helicopter as an example, carrying a line means 26. The transfer of measurement values from the means for the measurement of physical data is performed via a fibre optical link 27, 28 to an optoconverter 29 and further to a computer 30 in the helicopter. The carrying line means 26 is kept connected to the helicopter 25 by a lifting releasable element 31, controlled from the helicopter. Furthermore the first and second parts 27 and 28 of the fibre optical link are kept in fibre optical connection by a connecting means 32, which is provided to bring the two parts to separate under the influence of a predetermined tensile force. This will thus happen if, in a situation of emergency, the lifting means must be separated from the device. The connecting means comprises two permanent magnets 33 and 34, which are kept under a certain pretension by a tensile spring 35.

## Claims

1. A device for the automatic control of joints (3A) in lines for electric high voltage, the device comprising
a) a support (1),
b) at least one driving wheel (2) for engaging a line (3),
c) a driving device (4) for driving said wheel (2).
d) a first remote control device (5,6) for the control of said driving device (4),
e) means (12,13,14,36), for remotely controlled, automatic measurement of physical data at said joint (3A) comprising necessary circuits (14), and means for the transfer of measurement data to a receiver, said means (12,13,14,36) for remotely controlled, automatic measurement of physical data being designed for non contacting as well as contacting measurement in the vicinity of and at the joint in question,
f) shielding means (15) for shielding the means (12,13,14,36) according to e) above, to achieve a uniform potential.
**characterised in that**
the device for automatic control of joints that is releasably arranged to be carried by a lifting means like a helicopter or crane is provided with guide rail means (7,8,9) diverging downwards, designed for steering from above the device for automatic control of joints to resting engagement of the driving wheel (2) upon the line (3),
and that there is provided a means for the measurement of electric voltage over the joint (3A) comprising two pointed elements (12, 13) which are provided to automatically, by remote control, be brought to penetrate into the surface layer of the line (3) and thus form the ends of an electrical measurement shunt circuit over the joint.

2. A device according to claim 1,
**characterised in that**
the support (1) in addition to said driving wheel (2) is provided with at least one second wheel (21), parallel, at a distance perpendicular to said driving wheel (2), the second wheel being adjustable as to the distance perpendicular to the driving wheel (2).

3. A device according to claim 1 or 2
**characterised in that**
there is a remotely controlled releasable lifting element between the support (1) and said lifting means, which lifting element comprises a guide means (16) attached to said support (1), preferably in the form of a hopper, diverging upwardly, the guide means being provided with a first locking element (17), and that it comprises a second locking element (18), which is attached to a cable means (19) intended to be carried by said lifting means, the first and second locking elements (17,18) being provided to automatically form together said lifting element in the form of a locking, remotely controlled, releasable carrying joint.

4. A device according to claim 3
**characterised in that**
insulators are provided between the lifting elementf and the support (1).

5. A device according to any of claims 1 to 4,
**characterised in that**
the means for the transfer of measurement data to the receiver comprises a fibre optical Link (27, 28).

6. A device according to claim 5,
**characterised in that**
the fibre optical link (27, 28) comprises a first and second part, which are kept in fibre optical connection by a connection means (32), which is provided to bring the two parts apart under the influence of a predetermined tensile force.

7. A device according to any of claims 1 to 6,
**characterised in that**
a means (36) for the measurement of the amperage through the joint (3A) comprises a measurement loop, (39, 40, 42) which is formed from at least two clamp parts, so that it opens automatically and then closes around a line (3) when it is led towards this, and automatically opens when it is drawn from the line (3).

## Patentansprüche

1. Anordnung zur automatischen Kontrolle von Verbindungen (3A) in elektrischen Hochspannungsleitungen, mit:
a) einem Träger (1),
b) mindestens einem Antriebsrad (2) zum Eingriff mit einer Leitung (3),
c) einer Antriebseinrichtung (4) zum Antrieb des Rades (2),
d) einer ersten Fernsteuereinrichtung (5, 6) zur Steuerung der Antriebseinrichtung (4),
e) Mitteln (12, 13, 14, 36) zur ferngesteuerten automatischen Messung von physikalischen Daten der Verbindung (3A) mit erforderlichen Schaltungen (14) und Mitteln zur Übertragung von gemessenen Daten zu einem Empfänger, wobei die Mittel (12, 13, 14, 36) zur ferngesteuerten automatischen Messung von physikalischen Daten sowohl zur kontaktlosen, als auch zur kontaktbehafteten Messung in der Umgebung der betreffenden Verbindung und an der betreffenden Verbindung vorgesehen sind,
f) einer Abschirmeinrichtung (15) zur Abschirmung der oben unter e) genannten Mittel (12, 13, 14, 36), um ein gleichmäßiges Potential zu erzielen,
**dadurch gekennzeichnet, dass**
die Anordnung zur automatischen Kontrolle von Verbindungen, die lösbar angeordnet ist, um durch eine Anhebeeinrichtung wie einen Hubschrauber oder einen Kran getragen zu werden, mit nach unten divergierenden Führungsschienen (7, 8, 9) versehen ist, die zur Steuerung der Anordnung zur automatischen Kontrolle von Verbindungen von oben in der Weise ausgebildet sind, dass das Antriebsrad (2) in einen auf der Leitung (3) ruhenden Eingriff kommt, und dass
ein Mittel zur Messung der elektrischen Spannung über der Verbindung (3A) vorgesehen ist, das zwei spitze Elemente (12,13) aufweist, die dazu vorgesehen sind, automatisch durch Fernsteuerung in eine Oberflächenschicht der Leitung (3) einzudringen und auf diese Weise die Enden eines elektrischen Messkreises über der Verbindung zu bilden.

2. Anordnung nach Anspruch 1,
**dadurch gekennzeichnet, dass** der Träger (1) zusätzlich zu dem Antriebsrad (2) mit mindestens einem zweiten Rad (21) parallel und mit einem Abstand senkrecht zu dem Antriebsrad (2) versehen ist, wobei das zweite Rad im Hinblick auf den Abstand senkrecht zu dem Antriebsrad (2) einstellbar ist.

3. Anordnung nach Anspruch 1 oder 2,
**dadurch gekennzeichnet, dass** ein ferngesteuertes lösbares Anhebeelement zwischen dem Träger (1) und der Anhebeeinrichtung vorgesehen ist, wobei das Anhebeelement ein an dem Träger (1) befestigtes Führungsmittel (16), vorzugsweise in Form eines Trichters, aufweist, der nach oben divergiert, wobei das Führungsmittel mit einem ersten Verriegelungselement (17) versehen ist, und dass ein zweites Verriegelungselement (18) vorgesehen ist, das an einem Kabelteil (19) befestigt ist, das dazu vorgesehen ist, durch die Anhebeeinrichtung getragen zu werden, wobei das erste und das zweite Verringerungselement (17, 18) so vorgesehen ist, dass sie zusammen automatisch das Anhebeelement in Form einer verriegelnden, ferngesteuerten, lösbaren, tragenden Verbindung bilden.

4. Anordnung nach Anspruch 3,
**dadurch gekennzeichnet, dass** zwischen dem Anhebeelement und dem Träger (1) Isolatoren vorgesehen sind.

5. Anordnung nach einem der Ansprüche 1 bis 4,
**dadurch gekennzeichnet, dass** die Einrichtung zur Übertragung von Messdaten zu dem Empfänger eine optische Faserverbindung (27, 28) umfasst.

6. Anordnung nach Anspruch 5,
**dadurch gekennzeichnet, dass** die optische Faserverbindung (27, 28) ein erstes und ein zweites Teil umfasst, die mit einer Verbindungseinrichtung (32) in faseroptischer Verbindung gehalten werden, wobei die Verbindungseinrichtung dazu vorgesehen ist, die zwei Teile unter dem Einfluss einer vorbestimmten Zugkraft auseinander zu halten.

7. Anordnung nach einem der Ansprüche 1 bis 6,
**dadurch gekennzeichnet, dass** eine Einrichtung (36) zur Messung der Stromstärke in der Verbindung (3A) eine Messschleife (39, 40, 42) umfasst, die aus mindestens zwei Klemmteilen gebildet ist, so dass sie sich automatisch öffnet und dann um eine Leitung (3) schließt, wenn sie zu dieser geführt wird, und automatisch öffnet, wenn sie von der Leitung (3) weggezogen wird.

## Revendications

1. Dispositif pour la commande automatique de jonctions (3A) dans des lignes électriques à haute tension, le dispositif comportant :
a) un support (1),
b) au moins une roue d'entraînement (2) pour venir en prise avec une ligne (3),
c) un dispositif d'entraînement (4) pour entraîner ladite roue (2),
d) un premier dispositif de commande à distance (5, 6) pour la commande dudit dispositif d'entraînement (4),
e) des moyens (12, 13, 14, 36) de mesure automatique commandée à distance de données physiques au niveau de ladite jonction (3A) comportant des circuits nécessaires (14), et des moyens pour le transfert de données de mesure jusqu'à un récepteur, lesdits moyens (12, 13, 14, 36) de mesure automatique commandée à distance de données physiques étant conçus pour effectuer une mesure sans contact ainsi qu'une mesure avec contact à proximité et au niveau de la jonction en question,
f) des moyens de blindage (15) pour blinder les moyens (12, 13, 14, 36) conformément aux moyens e) cités ci-dessus, pour obtenir un potentiel uniforme,
**caractérisé en ce que**
le dispositif de commande automatique de jonctions, qui est agence d'une manière détachable pour être porté par des moyens de levage tels qu'un hélicoptère ou une grue, est muni de moyens de rail de guidage (7, 8, 9) divergeant vers le bas, conçus pour être dirigés à partir du dessus du dispositif de commande automatique de jonctions jusqu'à une mise en prise d'arrêt de la roue d'entraînement (2) sur la ligne (3),
et **en ce que** l'on fournit des moyens pour la mesure de la tension électrique sur la jonction (EA) comportant deux éléments pointus (12, 13) qui sont fournis de manière à être automatiquement, par une commande à distance, amenés a pénétrer dans la couche superficielle de la ligne (3) et former par conséquent les extrémités d'un circuit de dérivation de mesure électrique sur la jonction.

2. Dispositif selon la revendication 1,
**caractérisé en ce que**
le support (1) en plus de ladite roue d'entraînement (2) est muni d'au moins une seconde roue (21), parallèle, à une distance perpendiculaire à ladite roue d'entraînement (2), la seconde roue étant ajustable en ce qui concerne la distance perpendiculaire à la roue d'entraînement (2).

3. Dispositif selon la revendication 1 ou 2,
**caractérisé en ce que**
un élément de levage détachable et commandé à distance se trouve entre le support (1) et lesdits moyens de levage, lequel élément de levage comporte des moyens de guidage (16) fixés sur ledit support (1), de préférence sous la forme d'une trémie, divergeant vers le haut, les moyens de guidage étant munis d'un premier élément de verrouillage (17), et **en ce qu'**il comporte un second élément de verrouillage (18), qui est fixé sur des moyens de câble ( 19) prévus pour être portés par lesdits moyens de levage, les premier et second éléments de verrouillage (17, 18) étant fournis pour automatiquement former ensemble ledit élément de levage sous la forme d'un verrouillage commandé à distance, libérable, portant une jonction.

4. Dispositif selon la revendication 3,
**caractérisé en ce que**
des isolateurs sont fournis entre l'élément de levage et le support (1).

5. Dispositif selon l'une quelconque des revendications 1 à 4,
**caractérisé en ce que**
les moyens pour le transfert de données de mesure jusqu'au récepteur comportent une liaison à fibre optique (27, 28).

6. Dispositif selon la revendication 5,
**caractérisé en ce que**
la liaison à fibre optique (27, 28) comporte une première et une seconde partie, qui sont maintenues en connexion de fibre optique par des moyens de connexion (32), qui sont fournis pour amener les deux parties séparées sous l'influence d'une force de traction prédéterminée.

7. Dispositif selon l'une quelconque des revendications 1 à 6,
**caractérisé en ce que**
des moyens (36) pour la mesure de l'intensité de courant aux bornes de la jonction (3A) comportent une boucle de mesure (39, 40, 42), qui est formée d'au moins deux parties de serrage, de sorte qu'elle s'ouvre automatiquement et se ferme ensuite autour d'une ligne (3) lorsqu'elle est amenée vers celle-ci, et s'ouvre automatiquement lorsqu'elle est tirée à partir de la ligne (3).
